# EUROPÄISCHE PATENTSCHRIFT

(11) **EP 3 295 775 B1**
(45) Veröffentlichungstag und Bekanntmachung des Hinweises auf die Patenterteilung: **01.12.2021**
(21) Anmeldenummer: 16719379.6
(22) Anmeldetag: 27.04.2016
(51) Int. Cl.: H05K 7/14, H05K 9/00

(54) **FELDGERÄT ZUM EINSATZ IN DER PROZESSAUTOMATISIERUNG**
FIELD DEVICE FOR USE IN PROCESS AUTOMATION
APPAREIL DE TERRAIN À METTRE EN OEUVRE DANS L'AUTOMATISATION DE PROCESSUS

(30) Priorität: 11.05.2015 DE 102015107306
(43) Veröffentlichungstag der Anmeldung: 21.03.2018
(73) Patentinhaber: Endress+Hauser SE+Co. KG, 79689 Maulburg (DE)
(72) Erfinder: MICHALSKI, Bernhard, 79689 Maulburg (DE); GRITTKE, Udo, 79585 Steinen (DE); SCHROTH, Herbert, 79650 Schopfheim (DE); STRÜTT, Bernd, 79585 Steinen (DE)
(74) Vertreter: Andres, Angelika Maria
(86) Internationale Anmeldenummer: PCT/EP2016/059359
(87) Internationale Veröffentlichungsnummer: WO 2016/180635

(56) Entgegenhaltungen:
- EP-A1- 0 048 488
- WO-A2-2014/013480
- DE-A1-102011 088 302
- US-A1- 2002 180 108
- US-A1- 2006 055 006
- US-A1- 2009 130 530
- US-A1- 2014 190 841

## Beschreibung

Die Erfindung beschreibt ein Feldgerät zum Einsatz in der Prozessautomatisierung, umfassend ein Gehäuse zur EMV-Abschirmung, das einen Innenraum umschließt, welcher aus zumindest einer ersten und einer zweiten Kammer besteht, zumindest einen Sensor, der in der ersten Kammer angeordnet ist, zur Messumwandlung von einer physikalischen Grüße in eine erste elektronische Messgröße, zumindest eine erste elektronische Schaltung, die in der ersten Kammer angeordnet ist, zum Betreiben des Sensors und Verarbeiten der ersten Messgröße in ein Zwischensignal, zumindest eine zweite elektronische Schaltung zum Speisen der ersten elektronischen Schaltung und Umwandlung des Zwischensignals in ein Ausgangssignal, das über eine Anschlussleitung ausgegeben werden kann und zumindest eine elektrisch leitfähige Barriere, die die zumindest ersten beiden Kammern räumlich voneinander trennt und diese dadurch verschiedene EMV-Bereiche darstellen.

Aus dem Stand der Technik sind bereits Feldgeräte bekannt geworden, die in industriellen Anlagen zum Einsatz kommen. In der Prozessautomatisierungstechnik ebenso wie in der Fertigungsautomatisierungstechnik werden vielfach Feldgeräte eingesetzt. Als Feldgeräte werden im Prinzip alle Geräte bezeichnet, die prozessnah eingesetzt werden und die prozessrelevante Informationen liefern oder verarbeiten. So werden Feldgeräte zur Erfassung und/oder Beeinflussung von Prozessgrößen verwendet. Zur Erfassung von Prozessgrößen dienen Messgeräte, bzw. Sensoren. Diese werden beispielsweise zur Druck- und Temperaturmessung, Leitfähigkeitsmessung, Durchflussmessung, etc. verwendet und erfassen die entsprechenden Prozessvariablen Druck, Temperatur, Leitfähigkeit, pH-Wert, Füllstand, Durchfluss etc. Zur Beeinflussung von Prozessgrößen werden Aktoren verwendet. Diese sind beispielsweise Pumpen oder Ventile, die den Durchfluss einer Flüssigkeit in einem Rohr oder den Füllstand in einem Behälter beeinflussen können. Neben den zuvor genannten Messgeräten und Aktoren werden unter Feldgeräten auch Remote I/Os, Funkadapter bzw. allgemein Geräte verstanden, die auf der Feldebene angeordnet sind.

Eine Vielzahl solcher Feldgeräte wird von der Endress+Hauser-Gruppe produziert und vertrieben. Das Dokument US2006/055006A1 offenbart ein Feldgerät aus dem Oberbegriff des Anspruchs 1.

Viele Feldgeräte für die Prozessautomatisierung sind unterschiedlichen Umwelteinflüssen, abhängig ihres Einsatzortes, ausgesetzt. In verschiedenen Industriebereichen sind somit unterschiedliche Einflüsse vorherrschend, die jeweils verschiedene Schutzmaßnahmen benötigen.

Etablierte Lösungen stellen Gehäuse aus Metall dar. Diese sind beispielsweise aus VA, Aluminium, o.ä. gefertigt. Zum Zweck der Korrosionsvermeidung werden diese Metallgehäuse mit unterschiedlichen Beschichtungen versehen. Dies ist jedoch mitunter ein teurer Verfahrensschritt.

Ebenso werden Kunststoffgehäuse angeboten. Diese haben aus Korrosionssicht erhebliche Vorteile gegenüber Metallgehäusen, haben aber den Nachteil, dass sie aus Sicht der mechanischen Robustheit den Metallgehäusen unterlegen sind. Für Hersteller von Feldgeräten ergibt sich daraus die Konsequenz, dass Geräte sowohl mit Metallgehäusen als auch mit Kunststoffgehäusen angeboten werden müssen.

Für die in den Gehäusen untergebrachten elektronischen Schaltungen ergeben sich daraus aber aus Sicht des EMV-Schutzes erhebliche Unterschiede, die sich in unterschiedlich erforderlichen Schutzmaßnahmen für Metall und Kunststoff niederschlagen und damit erheblichen Mehraufwand in der Entwicklung ergeben. Im Stand der Technik werden Kunststoffgehäuse mit einer dünnen Metallschicht an der Gehäuseinnenseite versehen, die mittels verschiedener Methoden, wie beispielsweise Aufdampfen, Lackieren, Sputtern, Galvanisieren, etc. aufgebracht werden können und dadurch einen Faraday'schen Käfig bilden. Diese Schichten sind allerdings sehr dünn und können für keine zusätzliche mechanische Stabilität des Gehäuses sorgen, außerdem sind diese genannten Fertigungsprozesse mitunter kostenintensiv.

Aufgabe der vorliegenden Erfindung ist es nun, ein Feldgerät zum Einsatz in der Prozessautomatisierung zu schaffen, dessen Gehäuse kostengünstig gefertigt werden kann.

Die Aufgabe wird durch ein Feldgerät nach Anspruch 1 gelöst, wobei das Feldgerät ein Gehäuse umfasst, das aus einem Gehäusekern aus leitfähigem Material und einem den Gehäusekern allseitig umgebenden Gehäusemantel aus nicht leitfähigem Material besteht.

Gemäß einer bevorzugten Ausgestaltung besteht der Gehäusekern aus Metall, der den Gehäusekern allseitig umgebende Gehäusemantel ist aus Kunststoff gefertigt.

Der Vorteil in der Wahl dieser Materialien besteht darin, dass das Gehäuse kostensparend gefertigt werden kann, da aufwändige Beschichtungen des Metallgehäuses oder das Auftragen dünner Metallschichten auf den Kunststoff nicht benötigt werden.

Das erfindungsgemäße Feldgerät bietet außerdem den Vorteil, dass es universell in unterschiedlichsten Industriebereichen unabhängig von Umwelteinflüssen einsetzbar ist. Der Gehäusekern bietet die erforderliche Robustheit gegenüber mechanischen Einflüssen. Der den Gehäusekern allseitig umgebende Gehäusemantel bringt den besten Korrosionsschutz. Durch den leitfähigen Gehäusekern ist außerdem eine Abschirmung von elektromagnetischen Störungen gewährleistet.

Gemäß einer Ausgestaltung ist der Gehäusekern aus zumindest einem, bevorzugt zwei oder mehreren einzelnen Komponenten zusammengesetzt.

Gemäß einer Ausführung ist der den Gehäusekern allseitig umgebende Gehäusemantel kraftschlüssig oder stoffschlüssig auf den Gehäusekern aufgebracht, was für zusätzliche mechanische Stabilität sorgt.

Gemäß einer bevorzugten Ausgestaltung ist der den Gehäusekern allseitig umgebende Gehäusemantel durch ein Spritzgussverfahren auf den Gehäusekern aufgebracht.

Durch die Fertigung mittels Spritzgussverfahren lassen sich hohe Stückzahlen bei geringen Fertigungspreisen erzielen. Der Fertigungsprozess ist gegenüber bisherigen Herstellungsprozessen von Gehäusen für Feldgeräte beschleunigt, da auf spezielle Oberflächenbehandlungen der verwendeten Komponenten verzichtet werden kann.

Gemäß einer bevorzugten Variante ist der den Gehäusekern allseitig umgebende Gehäusemantel durch eine Schrumpfverbindung auf den Gehäusekern aufgebracht.

Diese Variante ist in DE102014105569A1 für Halbschalen des Gehäuses eines magnetisch induktiven Messgeräts beschrieben und bietet den Vorteil einer sehr schnellen Fertigung bei niedrigen Fertigungskosten.

Gemäß einer vorteilhaften Ausgestaltung ist der den Gehäusekern allseitig umgebende Gehäusemantel durch eine Schnappverbindung auf den Gehäusekern aufgebracht.

Gemäß einer bevorzugten Ausführung ist der den Gehäusekern allseitig umgebende Gehäusemantel durch eine Schraubverbindung auf den Gehäusekern aufgebracht.

Gemäß einer vorteilhaften Variante ist der den Gehäusekern allseitig umgebende Gehäusemantel durch eine Nietverbindung auf den Gehäusekern aufgebracht.

Gemäß einer bevorzugten Ausführung ist der den Gehäusekern allseitig umgebende Gehäusemantel durch eine Klebeverbindung auf den Gehäusekern aufgebracht.

Gemäß einer Weiterbildung wird als zumindest erste elektrisch leitfähige Barriere eine Leiterplatte mit einer Durchgangsbohrung zum Verbinden der ersten und der zweiten elektronischen Schaltung verwendet, die auf einen elektrisch leitenden Bereich des Gehäusekerns aufgelegt und verbunden ist, wodurch verschiedene Kammern im Innenraum des Gehäuses mit unterschiedlichen EMV-Schutzgraden geschaffen werden können.

Die Sensorelektronik der ersten elektronischen Schaltung kann dadurch außerdem von der Elektronik einer zweiten, signalverarbeitenden Schaltung getrennt werden, was Störeinflüsse verringert. Die Durchgangsbohrung erlaubt das elektrische Verbinden der ersten und der zweiten elektronischen Schaltung miteinander.

Gemäß einer vorteilhaften Ausgestaltung sind elektrische Erdungskontakte, die mit dem Gehäusekern in elektrischer Verbindung sind, durch den Gehäusemantel durchgeführt und mit einem korrosionsbeständigen Kontakt ausgestattet, wodurch eine externe Erdung angelegt werden kann.

Gemäß der Erfindung ist im Innenraum zumindest eine Erdungsklemme so angebracht und angeordnet, dass diese am Gehäusekern elektrisch kontaktiert ist. Dadurch kann eine, von einem externen Kommunikationssignal mitgebrachte Erdung mit dem Gerätekern in Verbindung gebracht werden.

Gemäß der Erfindung sind Bereiche des Gehäusekerns durch den Mantel in den Innenraum geführt, wodurch Erdungsanschlüsse der ersten elektronischen Schaltung mittels Federkontakten elektrisch kontaktiert sind.

Gemäß einer Ausgestaltung sind Übergänge zwischen dem Gehäuse und beispielsweise einer Sensoreinheit so angebracht und angeordnet, dass diese durch Gewinde und/oder Schleifkontakte elektrisch mit dem Gehäusekern verbunden sind, was einen einfachen Austausch dieser Komponenten ermöglicht, ohne dass durch den Tausch das gesamte Gehäuse ersetzt werden müsste.

Gemäß einer Ausführung sind die Übergänge mit Dichtungen, beispielsweise Silikondichtungen o.ä. versehen, die die Übergänge vor Umwelteinflüssen schützen.

Dadurch kann das Feldgerät selbst in Prozessumgebungen mit widrigen Umwelteinflüssen eingesetzt werden.

Gemäß einer vorteilhaften Ausgestaltung ist ein Gerätedeckel so angebracht und angeordnet, dass er elektrisch mit dem Gehäusekern verbunden ist.

Die Möglichkeit, den elektrisch leitfähigen Gehäusekern durch in den Innenraum geführte Bereiche mittels Federkontakten zu kontaktieren, beispielsweise für Erdungsanschlüsse der enthaltenen Elektronik, und die Option, Sensoren, Deckel oder andere Elemente mittels Gewinden und/oder Schleifkontakten elektrisch mit dem Gehäusekern zu verbinden, bietet die Möglichkeit eines universalen Einsatzes für verschiedenste Ausführungsformen des Feldgeräts.

Ein weiterer Vorteil ergibt sich dadurch, dass es möglich ist, bedingt durch die elektrische Isolation aufgrund des nicht leitfähigen Gehäusemantels an der Innenseite des Gehäuses, Schaltungsleitungen eng an der Innenseite des Gehäuses anzuordnen, ohne dass es einen Kurzschluss aufgrund einer Kontaktierung dieser Leitungen mit der Gehäusemasse gibt.

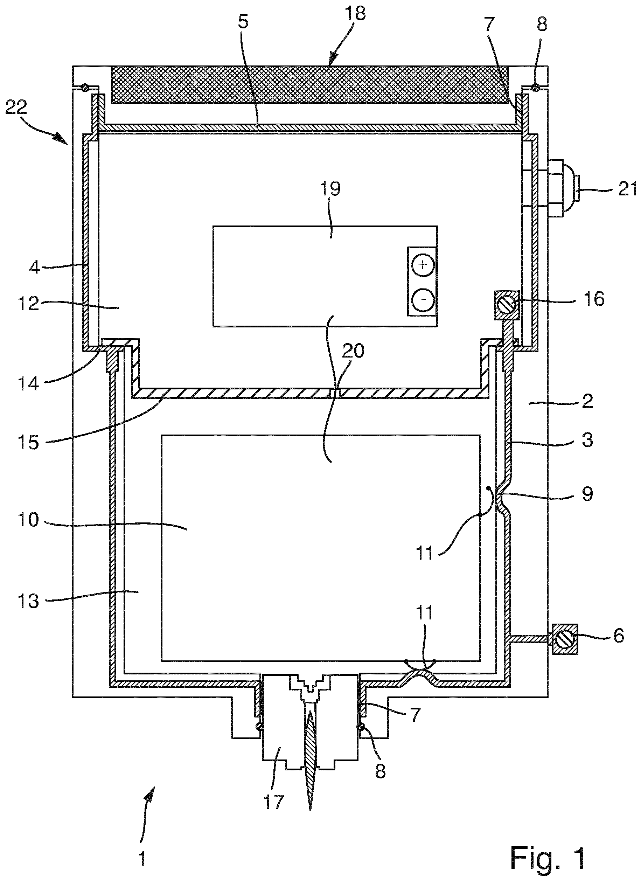

Die Erfindung wird anhand der nachfolgenden Figur näher erläutert. Es zeigt
Fig. 1 einen Querschnitt eines erfindungsgemäßen Feldgeräts 1.

Fig. 1 zeigt einen Querschnitt eines erfindungsgemäßen Feldgeräts 1 am Beispiel eines Messgerätes. Der elektrisch leitfähige Gehäusekern 3 bildet die Basis des Gehäuses 22. Durch den Gehäusekern 3 ist die mechanische Stabilität des Gehäuses 22 gewährleistet. Der Gehäusekern 3 kann als ein dünnes, tiefgezogenes Blech, beispielsweise aus Kupfer, VA, Eisen, etc., oder aus einem geeigneten Gussverfahren, wie beispielsweise Aluminiumdruckguss, ausgeformt werden und umschließt einen Innenraum. Der Gehäusekern 3 kann dabei aus einem oder mehreren Teilen bestehen. So kann beispielsweise eine Deckeleinheit 18, bestehend aus derselben Materialkombination wie das Gehäuse 22 selbst, implementiert werden.

Der Gehäusekern 3 ist allseitig von einem nichtleitfähigen Gehäusemantel 2 umgeben. Dieser besteht aus einem Kunststoff, beispielsweise Polyamid (PA), Polyetheretherketon (PEEK), etc. und kann mittels diverser Verfahren, wie Umspritzen, einer Schnappverbindung, einer Schrumpfverbindung, einer Schraubverbindung, einer Nietverbindung oder einer Klebeverbindung mit dem Gehäusekern 3 kraft- oder stoffschlüssig verbunden werden.

Zumindest eine Leiterplatte 15 wird als elektrisch leitfähige Barriere auf einen elektrisch leitenden, freiliegenden Bereich 14 des Gehäusekerns 3 gelegt und elektrisch verbunden. Dadurch wird der Innenraum des Gehäuses in zumindest zwei Bereiche unterteilt, die jeweils von einem Faraday'schen Käfig, den Gehäusekern 3 und Leiterplatte 15 bilden, umgeben ist. Dadurch werden zumindest zwei Kammern 12, 13 gebildet, die unterschiedliche EMV-Schutzgrade ausweisen können. Die erste elektronische Schaltung 10 und die zweite elektronische Schaltung 19 sind beabstandet voneinander in den jeweiligen Kammern 12, 13 angeordnet. Da das primäre Sensorsignal sehr störanfällig ist, muss der EMV-Schutzgrad in der ersten Kammer 13 hoch sein, weswegen Informationen mit der Umwelt mittels einer Anschlussleitung 21 in der zweiten Kammer 12 ausgetauscht werden. Die Verbindung beider Schaltungen 10, 19 wird mittels einer Durchgangsbohrung 20 in der Leiterplatte 15 ermöglicht.

Zur Abschirmung von elektromagnetischen Störsignalen müssen der Faraday'sche Käfig, den der Gehäusekern 3 und die mit diesem verbundene Leiterplatte 15 bilden, und die elektrischen Schaltungen 10, 19, auf dasselbe Erdungspotential gelegt werden. Auf der Außenseite des Gehäusemantels 2 liegende, durch den Gehäusemantel 2 durchgeführte Erdungskontakte 6 bieten die Möglichkeit, eine externe Erdung anzulegen. Bringt das externe Kommunikationssignal über den Geräteanschluss, beispielweise über eine Buchse, eine eigene Erdung mit, so kann der Gehäusekern 3 über eine interne Erdungsklemme 16 auf dieses Erdungspotential gelegt werden. Elektronikelemente der elektronischen Schaltungen 10, 19 können über durch den Gehäusemantel 2 geführte Bereiche 9 des Gehäusekerns 3 beispielweise mittels Federkontakten 11 auf das Erdungspotential des Gehäusekerns 3 zugreifen.

Sind im Gehäuse 22 Übergänge 7 vorhanden, beispielsweise zwischen einer eingebauten Sensoreinheit 17 und dem Gehäuse 22, oder einer Deckeleinheit 18 und dem Gehäuse 22, so kann mittels Gewinden und/oder Schleifkontakten eine elektrische Verbindung hergestellt werden. Damit diese Übergänge 7 vor Umwelteinflüssen geschützt sind, werden diese mit Dichtungen 8 versehen. Diese Dichtungen 8 können beispielsweise Formdichtungen aus einem thermoplastischen Elastomer sein.

### Bezugszeichenliste

- 1: Feldgerät
- 2: Gehäusemantel
- 3: Gehäusekern
- 4, 5: Teile des Gehäusekerns
- 6: Erdungskontakt
- 7: Übergang
- 8: Dichtung
- 9: in den Innenraum hineinreichende Bereiche des Gehäusekerns
- 10: erste elektronische Schaltung
- 11: Federkontakte
- 12,13: Kammern
- 14: elektrisch leitender Bereich
- 15: Leiterplatte
- 16: Erdungskontakt in Innenraum
- 17: Sensoreinheit
- 18: Gehäusedeckel
- 19: zweite elektronische Schaltung
- 20: Durchgangsbohrung
- 21: Anschlussleitung
- 22: Gehäuse

## Patentansprüche

1. Feldgerät (1) zum Einsatz in der Prozessautomatisierung, umfassend
- ein Gehäuse (22) zur EMV-Abschirmung, das einen Innenraum umschließt, welcher aus zumindest einer ersten Kammer (13) und einer zweiten Kammer (12) besteht;
- zumindest einen Sensor (17), der in der ersten Kammer (13) angeordnet ist, zur Messumwandlung von einer physikalischen Größe in eine erste elektronische Messgröße;
- zumindest eine erste elektronische Schaltung (10), die in der ersten Kammer (13) angeordnet ist, zum Betreiben des Sensors (17) und Verarbeiten der ersten Messgröße in ein Zwischensignal;
- zumindest eine zweite elektronische Schaltung (20), die in der zweiten Kammer (12) untergebracht ist, zum Speisen der ersten elektronischen Schaltung (10) und Umwandlung des Zwischensignals in ein Ausgangssignal, das über eine Anschlussleitung ausgegeben werden kann;
- zumindest eine elektrisch leitfähige Barriere (15), die die zumindest ersten beiden Kammern (12, 13) räumlich voneinander trennt und diese dadurch verschiedene EMV-Bereiche darstellen;
**dadurch gekennzeichnet, dass**
das Gehäuse (22) aus einem Gehäusekern (3) aus leitfähigem Material und einem Gehäusemantel (2) aus einem nicht leitfähigen Material besteht, wobei der Gehäusemantel (2) den Gehäusekern (3) allseitig umgibt, indem der Gehäusemantel (2) auf der Außenseite und auf der Innenseite des Gehäusekerns (3) aufgebracht ist,
dass im Innenraum zumindest eine Erdungsklemme (16) so angebracht und angeordnet ist, dass diese am Gehäusekern und an der leitfähigen Barriere elektrisch kontaktiert ist, und
dass Bereiche des Gehäusekerns (3) durch den Mantel (2) in den Innenraum geführt sind (9), wodurch Erdungsanschlüsse der ersten elektronischen Schaltung mittels Federkontakten (11) elektrisch kontaktiert sind.

2. Feldgerät nach Anspruch 1, **dadurch gekennzeichnet, dass** der Gehäusekern (3) aus Metall besteht.

3. Feldgerät nach Anspruch 1 oder 2, **dadurch gekennzeichnet, dass** der den Gehäusekern (3) allseitig umgebende Gehäusemantel (2) aus Kunststoff besteht.

4. Feldgerät nach einem der vorhergehenden Ansprüche, **dadurch gekennzeichnet, dass** der Gehäusekern (3) aus zumindest einem, bevorzugt zwei (4, 5) oder mehreren einzelnen Komponenten zusammengesetzt ist.

5. Feldgerät nach einem der vorhergehenden Ansprüche, **dadurch gekennzeichnet, dass** der den Gehäusekern (3) allseitig umgebende Gehäusemantel (2) kraftschlüssig oder stoffschlüssig auf den Gehäusekern (3) aufgebracht ist.

6. Feldgerät nach einem der vorhergehenden Ansprüche, **dadurch gekennzeichnet, dass** der den Gehäusekern (3) allseitig umgebende Gehäusemantel (2) durch ein Spritzgussverfahren, und/oder durch eine Schrumpfverbindung, und/oder durch eine Schnappverbindung, und/oder durch eine Schraubverbindung, und/oder durch eine Nietverbindung, und/oder durch eine Klebeverbindung auf den Gehäusekern (3) aufgebracht ist.

7. Feldgerät nach einem der vorhergehenden Ansprüche, **dadurch gekennzeichnet, dass** die zumindest erste elektrisch leitfähige Barriere eine Leiterplatte (15) mit einer Durchgangsbohrung zum Verbinden der ersten und der zweiten elektronischen Schaltung (10, 20) ist, die auf einen elektrisch leitenden Bereich (14) des Gehäusekerns (3) aufgelegt und verbunden ist.

8. Feldgerät nach einem der vorhergehenden Ansprüche, **dadurch gekennzeichnet, dass** elektrische Erdungskontakte (6), die mit dem Gehäusekern in elektrischer Verbindung sind, durch den Gehäusemantel (2) durchgeführt und mit einem korrosionsbeständigen Kontakt ausgestattet sind.

9. Feldgerät nach einem der vorhergehenden Ansprüche, **dadurch gekennzeichnet, dass** Übergänge (7) so angebracht und angeordnet sind, dass diese durch Gewinde und/oder Schleifkontakte elektrisch mit dem Gehäusekern (3) verbunden sind.

10. Feldgerät nach Anspruch 9, **dadurch gekennzeichnet, dass** die Übergänge (7) mit Dichtungen (8) versehen sind, die vor Umwelteinflüssen schützen.

11. Feldgerät nach einem der vorherigen Ansprüche, **dadurch gekennzeichnet, dass** ein Gerätedeckel (19) so angebracht und angeordnet ist, dass er elektrisch mit dem Gehäusekern (3) verbunden ist.

## Claims

1. Field device (1) designed to be used in process automation, said device comprising:
- a housing (22) for EMC screening, which surrounds an interior space consisting at least of a first chamber (13) and a second chamber (12);
- at least one sensor (17), arranged in the first chamber (13), for the measurement conversion of a physical variable to a first electronic measured variable;
- at least a first electronic circuit (10), arranged in the first chamber (13), which is designed to operate the sensor (17) and process the first measured variable into an intermediate signal;
- at least a second electronic circuit (20), located in the second chamber 15 (12), designed to power the first electronic circuit (10) and convert the intermediate signal to an output signal which can be output via a connection line;
- at least an electrically conductive barrier (15) spatially separating the at least first two chambers (12, 13) and presenting these, as a result, as different EMC areas;
**characterized in that** the housing (22) consists of a housing core (3) made of conductive material and a housing envelope (2) made of non-conductive material, wherein the housing envelope (2) surrounds the housing core (3) on all sides as the housing envelope (2) is applied on the outside and on the inside of the housing core (3),
**in that** at least one grounding terminal (16) is mounted and arranged in the interior space in such a way that the grounding terminal has an electrical contact at the housing core and the conductive barrier, and **in that** areas of the housing core (3) are guided (9) through the envelope (2) into the interior space as a result of which ground connections of the first electronic circuit are in electrical contact by means of spring contacts (11).

2. Field device as claimed in Claim 1, **characterized in that** the housing core (3) is made of metal.

3. Field device as claimed in Claim 1 or 2, **characterized in that** the housing envelope (2) surrounding the housing core (3) on all sides is made from plastic.

4. Field device as claimed in one of the previous claims, **characterized in that** the housing core (3) consists of at least one, preferably two (4, 5) or more, individual components.

5. Field device as claimed in one of the previous claims, **characterized in that** the housing envelope (2) surrounding the housing core (3) on all sides is applied to the housing core (3) by means of a frictional connection or a substance-to-substance connection.

6. Field device as claimed in one of the previous claims, **characterized in that** the housing envelope (2) surrounding the housing core (3) on all sides is applied to the housing core (3) by an injection molding procedure, and/or by a shrink joint, and/or by a snap coupling, and/or by a screw connection, and/or by a rivet joint, and/or by an adhesive connection.

7. Field device as claimed in one of the previous claims, **characterized in that** the at least first electrically conductive barrier is a printed circuit board (15) with a through-bore to connect the first and the second electronic circuit (10, 20), wherein said circuit is placed and connected to an electrically conductive area (14) of the housing core (3).

8. Field device as claimed in one of the previous claims, **characterized in that** electrical grounding contacts (6), which are electrically connected to the housing core, are passed through the housing envelope (2) and are provided with a corrosion-resistant contact.

9. Field device as claimed in one of the previous claims, **characterized in that** transitions (7) are provided and arranged in such a way that they are electrically connected to the housing core (3) via threads and/or sliding contacts.

10. Field device as claimed in Claim 9, **characterized in that** the transitions (7) are provided with seals (8) that protect against environmental influences.

11. Field device as claimed in one of the previous claims, **characterized in that** a device cover (19) is mounted and arranged in such a way that it is electrically connected to the housing core (3).

## Revendications

1. Appareil de terrain (1) destiné à être utilisé dans l'automatisation de processus, lequel appareil comprend :
- un boîtier (22) pour le blindage CEM, qui entoure un espace intérieur constitué d'au moins une première chambre (13) et une deuxième chambre (12) ;
- au moins un capteur (17), disposé dans la première chambre (13), pour la conversion de mesure d'une grandeur physique en une première grandeur de mesure électronique ;
- au moins un premier circuit électronique (10), disposé dans la première chambre (13), destiné à faire fonctionner le capteur (17) et traiter la première grandeur mesurée en un signal intermédiaire ;
- au moins un deuxième circuit électronique (20), situé dans la deuxième chambre 15 (12), destiné à alimenter le premier circuit électronique (10) et convertir le signal intermédiaire en un signal de sortie qui peut être émis par une ligne de connexion ;
- au moins une barrière électriquement conductrice (15) séparant spatialement les au moins deux premières chambres (12, 13) et les présentant ainsi comme des régions CEM différentes ;
**caractérisé en ce que** le boîtier (22) se compose d'un noyau de boîtier (3) en matériau conducteur et d'une enveloppe de boîtier (2) en matériau non conducteur, l'enveloppe de boîtier (2) entourant le noyau de boîtier (3) de tous les côtés, l'enveloppe de boîtier (2) étant appliquée à l'extérieur et à l'intérieur du noyau de boîtier (3), **en ce qu'**au moins une borne de mise à la terre (16) est montée et disposée dans l'espace intérieur de manière à être en contact électrique avec le noyau de boîtier et avec la barrière conductrice, et **en ce que** des zones du noyau de boîtier (3) sont guidées (9) à travers le boîtier (2) dans l'espace intérieur, ce par quoi des connexions de mise à la terre du premier circuit électronique sont en contact électrique au moyen de contacts à ressort (11).

2. Appareil de terrain selon la revendication 1, **caractérisé en ce que** le noyau de boîtier (3) est en métal.

3. Appareil de terrain selon la revendication 1 ou 2, **caractérisé en ce que** l'enveloppe de boîtier (2) entourant de tous côtés le noyau de boîtier (3) est en matière plastique.

4. Appareil de terrain selon l'une des revendications précédentes, **caractérisé en ce que** le noyau de boîtier (3) est composé d'au moins un, de préférence de deux (4, 5) ou plusieurs composants individuels.

5. Appareil de terrain selon l'une des revendications précédentes, **caractérisé en ce que** l'enveloppe de boîtier (2) entourant de tous côtés le noyau de boîtier (3) est appliquée sur le noyau de boîtier (3) par liaison de force ou de matière.

6. Appareil de terrain selon l'une des revendications précédentes, **caractérisé en ce que** l'enveloppe de boîtier (2) entourant de tous côtés le noyau de boîtier (3) est appliquée sur le noyau de boîtier (3) par un procédé de moulage par injection, et/ou par un assemblage par rétraction, et/ou par un assemblage par encliquetage, et/ou par un assemblage par vis, et/ou par un assemblage par rivetage, et/ou par un assemblage par collage.

7. Appareil de terrain selon l'une des revendications précédentes, **caractérisé en ce que** l'au moins première barrière électriquement conductrice est une carte de circuit imprimé (15) pourvue d'un trou traversant pour connecter le premier et le deuxième circuit électronique (10, 20), lequel circuit est placé et connecté sur une zone électriquement conductrice (14) du noyau de boîtier (3).

8. Appareil de terrain selon l'une des revendications précédentes, **caractérisé en ce que** des contacts électriques de mise à la terre (6), qui sont en liaison électrique avec le noyau de boîtier, sont passés à travers l'enveloppe de boîtier (2) et sont pourvus d'un contact résistant à la corrosion.

9. Appareil de terrain selon l'une des revendications précédentes, **caractérisé en ce que** les transitions (7) sont montées et disposées de manière à être reliées électriquement au noyau de boîtier (3) au moyen de filets et/ou de contacts glissants.

10. Appareil de terrain selon la revendication 9, **caractérisé en ce que** les transitions (7) sont munies de joints (8) qui protègent contre les influences environnementales.

11. Appareil de terrain selon l'une des revendications précédentes, **caractérisé en ce qu'**un couvercle d'appareil (19) est monté et disposé de telle sorte à être relié électriquement au noyau de boîtier (3).
